# EUROPEAN PATENT APPLICATION

(11) **EP 4 797 926 A1**
(43) Date of publication of application: **26.08.2026**
(21) Application number: 25846208.4
(22) Date of filing: 07.08.2025
(51) Int. Cl.: H10K 59/80

(54) **DISPLAY PANEL AND DISPLAY APPARATUS**

(30) Priority: 31.12.2024 CN 202411989179
(71) Applicant: Wuhan Tianma Microelectronics Co., Ltd., Wuhan, Hubei 430205 (CN)
(72) Inventor: HUANG, Wei, Wuhan, Hubei 430205 (CN)
(74) Representative: Germain Maureau
(86) International application number: PCT/CN2025/113238
(87) International publication number: WO 2026/144155

(57) **Abstract**

A display panel and a display device are provided according to the embodiments of the present disclosure. The display panel includes: a plurality of sub-pixels located on a same side of a substrate and including first sub-pixels, second sub-pixels and third sub-pixels, and a shape of at least one of the first sub-pixels, the second sub-pixels and the third sub-pixels includes a circle; a plurality of color resist layers located on a side of the sub-pixels away from the substrate; and a plurality of partition portions partially surrounding the sub-pixels, and at least one of the plurality of partition portions includes a notch. The embodiments of the present disclosure can reduce the risk of diffraction effects generated when the sub-pixels emit light and the reflectivity of ambient light, so as to partition or extend a transmission path of a lateral leakage current between two adjacent sub-pixels through a common layer, thereby improving the display performance.

## Description

The present application claims priority to Chinese Patent Application No. 202411989179.8, titled "DISPLAY PANEL AND DISPLAY DEVICE", filed on December 31, 2024, with the China National Intellectual Property Administration, which is incorporated herein by reference in its entirety.

### TECHNICAL FIELD

The present disclosure relates to the field of display technologies, and in particular, to a display panel and a display device.

### BACKGROUND

Organic light-emitting diode (OLED) display panels are widely used in the field of display technologies due to their advantages such as active light emission, high contrast, and no viewing angle limitation.

In the OLED display panels, in order to enhance migration and recombination efficiency of charge carriers, functional film layers such as electron transport layers, electron injection layers, hole transport layers, and hole injection layers are typically arranged between an electrode and a light-emitting layer of an OLED device. However, these functional film layers are generally an entire surface structure which is used to cover all organic light-emitting devices in the display panel. During the display of the display panel, in addition to the normal longitudinal migration of charge carriers from their respective cathodes and/or anodes to the corresponding light-emitting layers, the charge carriers may migrate laterally between different OLED devices through these functional film layers, i.e., lateral leakage current. This lateral leakage current may result in crosstalk between different sub-pixels during the display of the display panel, such as a phenomenon where the sub-pixels that should not emit light may emit light, namely a light leakage phenomenon, thereby affecting the display performance.

### SUMMARY

In view of this, the present disclosure provides a display panel and a display device to solve the above problems.

In a first aspect, an embodiment of the present disclosure provides a display panel, including: a substrate; a plurality of sub-pixels located on a same side of the substrate; a plurality of color resist layers located on a side of the sub-pixels away from the substrate, and a plurality of partition portions. The plurality of sub-pixels include first sub-pixels, second sub-pixels, and third sub-pixels. An i-th row of the plurality of sub-pixels includes the first sub-pixels and the third sub-pixels alternately arranged along a first direction, and an (i+1)-th row of the plurality of sub-pixels includes the second sub-pixels and the third sub-pixels alternately arranged along the first direction. A j-th column of the plurality of sub-pixels includes the first sub-pixels and the third sub-pixels alternately arranged along a second direction, and a (j+1)-th column of the plurality of sub-pixels includes the second sub-pixels and the third sub-pixels alternately arranged along the second direction. A shape of at least one of the first sub-pixels, the second sub-pixels, and the third sub-pixels includes a circle. The plurality of color resist layers include a first color resist layer, a second color resist layer and a third color resist layer. Along a direction perpendicular to a plane of the substrate, the first color resist layer at least partially overlaps with one of the first sub-pixels, the second color resist layer at least partially overlaps with one of the second sub-pixels, and the third color resist layer at least partially overlaps with one of the third sub-pixels. The plurality of partition portions partially surround the sub-pixels, and at least one of the plurality of partition portions includes a notch.

In a second aspect, an embodiment of the present disclosure provides a display device including the above display panel.

According to the display panel and the display device provided by the embodiments of the present disclosure, a resistance layer is provided on the side of the sub-pixels away from the substrate. On the one hand, the light-emitting color accuracy of the sub-pixels can be improved, thereby improving the light-emitting effect of the display panel. On the other hand, the reflectivity of the display panel can be reduced, thereby reducing the interference of ambient light on the light emission of the display panel.

In addition, by adopting such arrangement manner, a polarizing layer does not need to be additionally arranged in the display panel, thereby reducing the thickness of the display panel. Moreover, in the embodiments of the present disclosure, the sub-pixels in the display panel are configured to include circular sub-pixels, which is beneficial to reducing the risk of diffraction effect generated when the sub-pixels emit light, avoiding the occurrence of stripes on the surface of the display panel, thereby making the light-emitting effect of the sub-pixels better, and improving the visual effect of the display panel.

Further, in the embodiments of the present disclosure, the partition portions are arranged around the sub-pixels, which is beneficial to partitioning or extending a transmission path of a lateral leakage current between two adjacent sub-pixels through a common layer, thereby suppressing the transmission of the lateral leakage current. In addition, in the embodiments of the present disclosure, by providing notches in the partition portions, the second electrode may be formed into a continuous structure with a larger thickness at the notches, thereby ensuring the full-surface continuity of the second electrode, reducing the risk of disconnection or reduction thickness of the second electrode, and thus improving the operating stability of the display panel.

### BRIEF DESCRIPTION OF DRAWINGS

In order to illustrate the technical solutions in the embodiments of the present disclosure more clearly, the drawings, which are intended to be used in the description of the embodiments, are briefly described as below. It will be apparent that other drawings described below are merely some embodiments of the present disclosure, and other drawings may be obtained by those skilled in the art according to these drawings without paying any creative efforts.
FIG. 1 is a top view of a display panel according to an embodiment of the present disclosure;
FIG. 2 is a cross-sectional schematic diagram of a display panel according to an embodiment of the present disclosure;
FIG. 3 is another cross-sectional schematic diagram of a display panel according to an embodiment of the present disclosure;
FIG. 4 is another cross-sectional schematic diagram of a display panel according to an embodiment of the present disclosure;
FIG. 5 is another cross-sectional schematic diagram of a display panel according to an embodiment of the present disclosure;
FIG. 6 is an enlarged schematic diagram of an area E1 shown in FIG. 1;
FIG. 7 is another partially enlarged schematic diagram of a display panel according to an embodiment of the present disclosure;
FIG. 8 is another partially enlarged schematic diagram of a display panel according to an embodiment of the present disclosure;
FIG. 9 is another partially enlarged schematic diagram of a display panel according to an embodiment of the present disclosure;
FIG. 10 is another cross-sectional schematic diagram of a display panel according to an embodiment of the present disclosure;
FIG. 11 is another partially enlarged schematic diagram of a display panel according to an embodiment of the present disclosure;
FIG. 12 is an enlarged schematic diagram of a first group according to an embodiment of the present disclosure;
FIG. 13 is an enlarged schematic diagram of a first subgroup according to an embodiment of the present disclosure;
FIG. 14 is a simplified schematic diagram of an outline of a second virtual trapezoid according to an embodiment of the present disclosure;
FIG. 15 is a simplified schematic diagram of an outline of a first subgroup according to an embodiment of the present disclosure;
FIG. 16 is another partially enlarged schematic diagram of a display panel according to an embodiment of the present disclosure;
FIG. 17 is another cross-sectional schematic diagram of a display panel according to an embodiment of the present disclosure; and
FIG. 18 is a schematic diagram of a display device according to an embodiment of the present disclosure.

### DESCRIPTION OF EMBODIMENTS

In order to better understand technical solutions of the present disclosure, embodiments of the present disclosure are described in detail below in conjunction with the drawings.

It should be clear that the described embodiments are only some rather than all of the embodiments of the present disclosure. All other embodiments obtained by those skilled in the art based on the embodiments of the present disclosure without creative efforts should fall within the protection scope of the present disclosure.

Terms used in the embodiments of the present disclosure are merely for the purpose of describing specific embodiments, but not intended to limit the present disclosure. The singular forms "a/an", "said", and "the" used in the embodiments of the present disclosure and the attached claims are also intended to include plural forms thereof, unless noted otherwise.

It should be understood that the term "and/or" used herein is merely an association relationship describing an associated object, and indicates that there may be three relationships. For example, A and/or B, and may indicate: only A, both A and B, and only B. In addition, the character "/" herein generally indicates an "or" relationship between the associated objects.

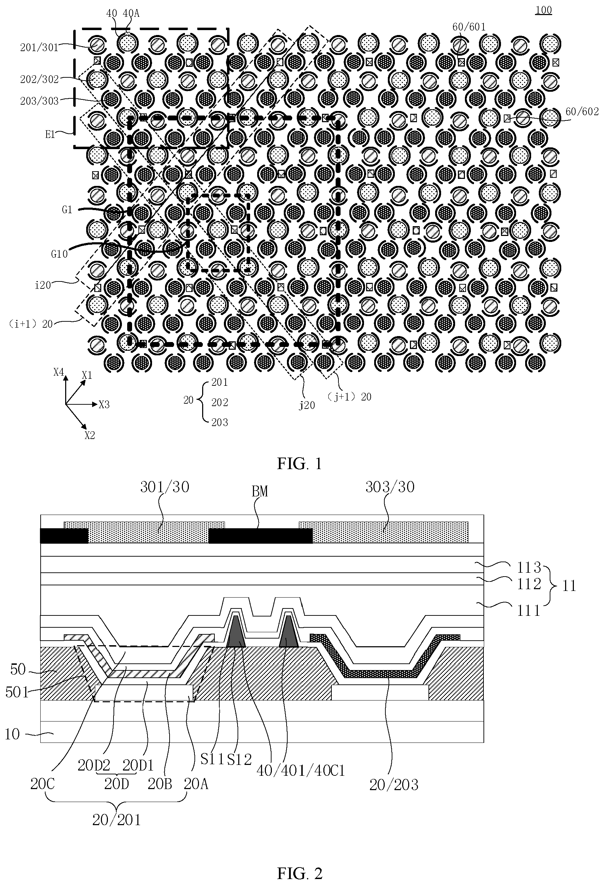

The embodiments of the present disclosure provides a display panel. As shown in FIG. 1 and FIG. 2, where FIG. 1 is a top view of a display panel according to an embodiment of the present disclosure, and FIG. 2 is a cross-sectional schematic diagram of a display panel according to an embodiment of the present disclosure, the display panel 100 includes a substrate 10 and a plurality of sub-pixels 20 located on the same side of the substrate 10. The plurality of sub-pixels 20 include first sub-pixels 201, second sub-pixels 202, and third sub-pixels 203. In an example, the first sub-pixels 201, the second sub-pixels 202 and the third sub-pixels 203 are sub-pixels of three different colors, such as red sub-pixels, green sub-pixels and blue sub-pixels.

With continued reference to FIG. 1, in the display panel 100, an i-th row of sub-pixels i20 includes the first sub-pixels 201 and the third sub-pixels 203 alternately arranged along a first direction X1, and an (i+1)-th row of sub-pixels (i+1)20 includes the second sub-pixels 202 and the third sub-pixels 203 alternately arranged along the first direction X1. A j-th column of sub-pixels j20 includes the first sub-pixels 201 and the third sub-pixels 203 alternately arranged along a second direction X2, and a (j+1)-th column of sub-pixels (j+1)20 includes the second sub-pixels 202 and the third sub-pixels 203 alternately arranged along the second direction X2. In an example, the first direction X1 and the second direction X2 intersect and are both parallel to a plane of the display panel 100, where i and j are both arbitrary positive integers.

In an example, as shown in FIG. 2, the display panel 100 further includes an encapsulation layer 11, a black matrix BM and a plurality of color resist layers 30 that are located on a side of the sub-pixels 20 away from the substrate 10. The black matrix BM may be located on a side of the encapsulation layer 11 away from the substrate 10, and include an opening. At least part of the color resist layer 30 is located in the opening of the black matrix BM. The light emitted from the sub-pixels 20 exits through the color resist layers 30, so as to improve the accuracy of the light-emitting color of the sub-pixels 20.

Exemplarily, when the sub-pixels 20 include the first sub-pixels 201, the second sub-pixels 202 and the third sub-pixels 203 that have different light-emitting colors, the color resist layers 30 accordingly include first color resist layers 301, second color resist layers 302 and third color resist layers 303. Along a direction perpendicular to the plane of the substrate 10, the first color resist layer 301 at least partially overlaps with the first sub-pixel 201, the second color resist layer 302 at least partially overlaps with the second sub-pixel 202, and the third color resist layer 303 at least partially overlaps with the third sub-pixel 203.

In addition, the color resist layers 30 may also reduce the reflectivity of the display panel 100 by absorbing incident ambient light. Further, based on such arrangement manner, it is equivalent that the color resist layer 30 is reused as a polarizer, so that the polarizer does not need to be additionally arranged on the light-emitting side of the display panel 100, which is beneficial to reducing the thickness of the display panel 100.

Exemplarily, a shape of at least one of the first sub-pixels 201, the second sub-pixels 202 and the third sub-pixels 203 includes a circle. As shown in FIG. 2, the display panel 100 further includes a pixel definition layer 50. The pixel definition layer 50 includes pixel openings 501. At least part of the sub-pixel 20 is prepared in the pixel opening 501, and the shape of the sub-pixel 20 is the same as that of the pixel opening 501. In some embodiments of the present disclosure, the shape of at least one of the first sub-pixels 201, the second sub-pixels 202 and the third sub-pixels 203 includes the circle, that is, the shape of the pixel opening where at least one of the first sub-pixels 201, the second sub-pixels 202 and the third sub-pixels 203 is located includes the circle.

In the related art, the shape of the sub-pixel is generally a square or a polygon which have relatively obvious corners. In order to reduce the reflection of ambient light to enable the display panel to have an integrated black effect, a black matrix BM usually needs to be prepared between adjacent sub-pixels. The black matrix BM is located on the light-emitting side of the sub-pixels 20, and the shape of the opening in the black matrix BM follows the shape of the sub-pixel. When the black matrix BM is prepared between adjacent square sub-pixels, the light emitted by the sub-pixel through the opening in the black matrix BM is equivalent to passing through a slit, which will cause a diffraction effect, resulting in a series of bright and dark stripes on the light-emitting surface of the display panel, thereby affecting the display performance of the display panel.

In the embodiments of the present disclosure, the shape of at least one of the first sub-pixels 201, the second sub-pixels 202, and the third sub-pixels 203 includes a circle, and when arranging the black matrix BM, the shape of the opening corresponding to the sub-pixel 20 in the black matrix BM can also be circular, so as to reduce the probability of diffraction effect generated when the sub-pixels 20 emit light, to avoid stripes on the surface of the display panel 100, thereby improving the visual effect of the display panel 100.

It should be noted that, considering process errors, the circular shape of the sub-pixels 20 may be circular within an allowable range of the process errors. For example, the actual shape of the sub-pixels 20 may be a shape similar to a standard circle.

Exemplarily, as shown in FIG. 2, the encapsulation layer 11 includes a first encapsulation layer 111, a second encapsulation layer 112, and a third encapsulation layer 113 that are stacked. For example, the first encapsulation layer 111 and the third encapsulation layer 113 may include an inorganic encapsulation layer, and the second encapsulation layer 112 may include an organic encapsulation layer.

With continued reference to FIG. 1, the display panel 100 further includes a plurality of partition portions 40. The partition portions 40 partially surround the sub-pixels 20. The partition portion 40 is located between adjacent sub-pixels 20. At least one partition portion 40 includes a notch 40A.

Exemplarily, as shown in FIG. 2, the sub-pixel 20 includes a first electrode 20A, a light-emitting layer 20B, a second electrode 20C and a common layer 20D. The partition portions 40 are located on a side of the common layer 20D close to the substrate 10. In an example, the common layer 20D includes a first common sub-layer 20D1 and a second common sub-layer 20D2. The first common sub-layer 20D1 is located between the first electrode 20A and the light-emitting layer 20B, and the second common sub-layer 20D2 is located between the second electrode 20C and the light-emitting layer 20B.

In the embodiments of the present disclosure, the pixel opening 501 of the pixel definition layer 50 exposes at least part of the first electrode 20A. The first electrodes 20A of different sub-pixels 20 are independent of each other. The second electrodes 20C of multiple sub-pixels 20 are electrically connected to each other. In an example, the first electrode 20A includes an anode, and the second electrode 20C includes a cathode. The first common sub-layer 20D1 includes a hole injection layer and/or a hole transport layer. The second common sub-layer 20D2 includes an electron injection layer and/or an electron transport layer.

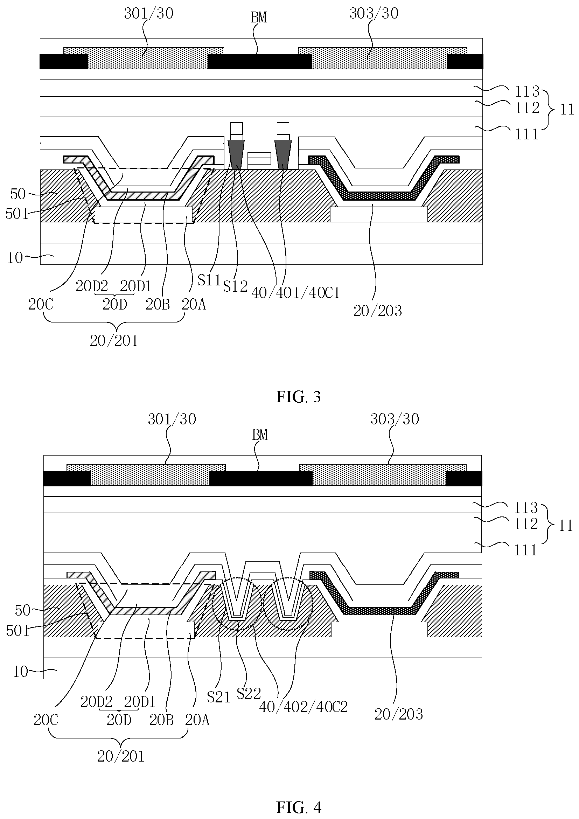

In the embodiments of the present disclosure, as shown in FIG. 2, FIG. 3, FIG. 4 and FIG. 5, where FIG. 3, FIG. 4 and FIG. 5 are another three cross-sectional schematic diagrams of the display panel according to embodiments of the present disclosure, the partition portion 40 includes at least one of a first partition sub-portion 40C1 and a second partition sub-portion 40C2.

As shown in FIG. 2 and FIG. 3, the first partition sub-portion 40C1 includes a protrusion 401 protruding away from the substrate 10. For example, a surface of the protrusion 401 away from the substrate 10 may extend beyond the pixel definition layer 50 to form a protrusion toward the light-emitting surface of the display panel 100.

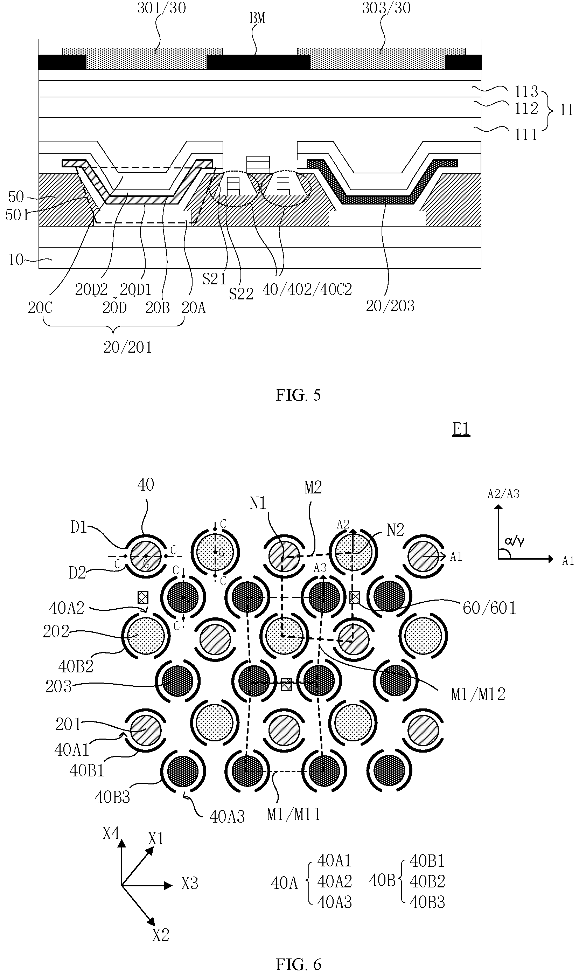

As shown in FIG. 4 and FIG. 5, the second partition sub-portion 40C2 includes a recess 402 recessed toward the substrate 10. In an example, in some embodiments of the present disclosure, the recess 402 may be formed in the pixel definition layer 50.

Exemplarily, as shown in FIG. 2 and FIG. 3, the protrusion 401 includes a first side surface S11, and a first bottom surface S12 that is arranged close to the substrate 10.

In an example, as shown in FIG. 2, in the embodiments of the present disclosure, an included angle between the first side surface S11 and the first bottom surface S12 toward the inside of the protrusion 401 may be an acute angle. That is, an area of a side of the protrusion 401 away from the substrate 1 is smaller than an area of a side of the protrusion 401 close to the substrate 1. Based on such arrangement manner, the common layer 20D formed after the formation of the protrusion 401 may be formed on the first side surface S11. Thus, the transmission path of the lateral leakage current between two adjacent sub-pixels 2 through the common layer 20D can be extended, thereby suppressing the transmission of the lateral leakage current and improving the display performance.

Alternatively, as shown in FIG. 3, in the embodiments of the present disclosure, an included angle between the first side surface S11 and the first bottom surface S12 toward the inside of the protrusion 401 may be an obtuse angle. That is, the area of the side of the protrusion 401 away from the substrate 10 is greater than the area of the side of the protrusion 401 close to the substrate 10. Based on such arrangement manner, the common layer 20D formed after the formation of the protrusion 401 cannot be formed on the first side surface S11 and thus is disconnected at the protrusion 401. Thus, the transmission path of the lateral leakage current between two adjacent sub-pixels 20 through the common layer 20D is partitioned, thereby suppressing the transmission of the lateral leakage current and improving the display performance.

In an example, as shown in FIG. 4 and FIG. 5, the recess 402 includes a second side surface S21, and a second bottom surface S22 that is arranged close to the substrate 10.

As shown in FIG. 4, an included angle between the second side surface S21 and the second bottom surface S22 may be an obtuse angle. Based on such arrangement manner, the common layer 20D formed after the formation of the recess 402 is formed on the second side surface S21 of the recess 402. Based on the morphology characteristics of the recess 402, the transmission path of the lateral leakage current between two adjacent sub-pixels 20 through the common layer 20D can be extended, thereby suppressing the transmission of the lateral leakage current and improving the display performance.

Alternatively, as shown in FIG. 5, an included angle between the second side surface S21 and the second bottom surface S22 may also be configured to be an acute angle, so that the common layer 20D formed after the formation of the recess 402 cannot be formed on the second side surface S21, and thus is disconnected at the recess 402. Thus, the transmission path of the lateral leakage current between two adjacent sub-pixels 20 through the common layer 20D is partitioned, thereby suppressing the transmission of the lateral leakage current and improving the display performance.

In the embodiments of the present disclosure, the partition portion 40 includes at least one of the first partition sub-portion 40C1 and the second partition sub-portion 40C2, which is beneficial to improving the structural diversity of the prepared partition portion 40, and is beneficial to adaptively preparing the first partition sub-portion 40C1 and the second partition sub-portion 40C2 according to the structural form between adjacent sub-pixels 20, thereby improving the application effect of the partition portion 40 for improving the lateral leakage current.

In the embodiments of the present disclosure, the partition portion 40 partially surrounds the sub-pixel 20, which is beneficial to extending the length of the common layer 20D arranged between adjacent sub-pixels 20 in multiple orientations, and extending the transmission path of the leakage current between two adjacent sub-pixels 20 in multiple orientations, thereby reducing the risk of leakage current between adjacent sub-pixels 20.

In the embodiments of the present disclosure, as shown in FIG. 1, at least one partition portion 40 includes a notch 40A, that is, the at least one partition portion 40 is a non-closed pattern including the notch 40A. When the partition portion 40 is configured to include the protrusion 401 shown in FIG. 2 or FIG. 3, or the recess 402 shown in FIG. 4 or FIG. 5, the partition portion 40 includes a notch 40A, which means that the partition portion 40 is formed as an approximately flat structure in which the partition portion 40 does not include the above protrusion and the above recess at a position of the notch 40A.

The arrangement of the notch 40A can prevent the second electrode 20C formed after the formation of the partition 40 from being disconnected or reduced in thickness at the notch 40A. The second electrode 20C is a continuous structure prepared between adjacent sub-pixels 20. During preparation, the second electrode 20C follows the shape of the partition portion 40 and forms an up-and-down climbing structure.

In the related art, there may be situations where the second electrode 20C is disconnected or reduced in thickness at the partition portion 40, resulting in a significant differentiation of resistances of the second electrode 20C at different positions of the display panel 100, and causing a risk of disconnection failure of the second electrode 20C at some positions.

Based on the method provided by the embodiments of the present disclosure, the notch 40A is prepared at the partition portion 40, so that the notch 40A is a smooth surface (the surface can be a surface of the pixel definition layer 50 facing the light-emitting surface of the display panel 100), so as to ensure that the structure of the subsequently prepared second electrode 20C at the notch 40A is relatively regular and smooth, to reduce the risk of the disconnection or thickness reduction of the second electrode 20C at the notch 40A, which is beneficial for ensuring the continuity of the second electrode 20C between adjacent sub-pixels 20. In this way, the second electrode 20C is formed as a continuous structure with a larger thickness at the notch 40A, thereby reducing the voltage drop of signals transmitted by the second electrode 20C during transmission, and improving the voltage uniformity of the second electrode 20C in the display area.

In an example, as shown in FIG. 1, the partition portion 40 corresponding to at least one of the first sub-pixels 201, the second sub-pixels 202, and the third sub-pixels 203 includes two notches 40A. As described above, the second electrode 20C may be formed as a relatively smooth and continuous structure with a certain thickness at the notch 40A, that is, at the notch 40A, the second electrode 20C does not include an obvious up-and-down climbing structure. In the embodiments of the present disclosure, the partition portion 40 corresponding to at least one of the first sub-pixels 201, the second sub-pixels 202 and the third sub-pixels 203 include two notches 40A, increasing the number of positions of the continuous structure in the second electrode 20C, thereby further reducing the risk of structural disconnection or thickness reduction when the second electrode 20C is continuously prepared between adjacent sub-pixels 20.

In an example, as shown in FIG. 1 and FIG. 6, where FIG. 6 is an enlarged schematic diagram of a region E1 shown in FIG. 1, a connecting line between centers C of the two notches 40A passes through a centroid G of an orthographic projection of the corresponding sub-pixel 20 on the plane of the substrate 10.

As shown in FIG. 6, the partition portion 40 includes a first endpoint D1 and a second endpoint D2. The notch 40A is located between the first endpoint D1 and the second endpoint D2, and a midpoint of the connecting line between the first endpoint D1 and the second endpoint D2 is the center C of the notch 40A.

It may be understood that in the embodiments of the present disclosure, the centroid G of the orthographic projection of the sub-pixel 20 on the plane of the substrate 10 may be defined as a mass distribution center point of the orthographic projection of the sub-pixel 20 on the plane of the substrate 10, that is, a center of mass. If the geometric shape of the orthographic projection of the sub-pixel 20 on the plane of the substrate 10 is a regular geometric shape, the geometric center of the orthographic projection of the sub-pixel 20 on the plane of the substrate 10 coincides with the centroid of the orthographic projection of the sub-pixel 20 on the plane of the substrate 10. For example, if the shape of the orthographic projection of the sub-pixel 20 on the plane of the substrate 10 is circular, the center of the circle is both the geometric center and the centroid. If the geometric shape of the orthographic projection of the sub-pixel 20 on the plane of the substrate 10 is an asymmetric irregular geometric shape, the centroid of the orthographic projection of the sub-pixel 20 on the plane of the substrate 10 may be determined through related technologies, but the geometric center of the orthographic projection of the sub-pixel 20 on the plane of the substrate 10 is difficult to determine. In this case, a relative positional relationship between the geometric center and the centroid of the orthographic projection of the sub-pixel 20 on the plane of the substrate 10 is difficult to determine.

It should be noted that a regular figure (a regular geometric shape) in the present disclosure satisfies at least one of the following conditions: 1) a centrally symmetric figure; and 2) an axially symmetric figure having more than two symmetry axes,such as, ellipses, parallelograms (non-rectangles and non-diamonds), circles, rounded rectangles, regular polygons, rectangles and diamonds are all regular figures. For the centrally symmetric figure, the point of symmetry serves as the center (centroid). For the axially symmetric figure having more than two symmetry axes, the intersection point of two symmetry axes is the center (centroid). Correspondingly, the figures other than the regular figures are irregular figures.

Exemplarily, as shown in FIG. 6, the centroid G of the sub-pixel 20 is located on the connecting line between the centers of the two notches 40A of the corresponding partition portion 40. In an example, in the circular sub-pixel 20, the centroid of the sub-pixel 20 may be at the midpoint of the connecting line between the centers of the two notches 40A.

In some embodiments of the present disclosure, the connecting line between the centers C of the two notches 40A passes through the centroid G of the orthographic projection of the corresponding sub-pixel 20 on the plane of the substrate 10, so that the two notches 40A surrounding the same corresponding sub-pixel 20 are located at two mutually symmetrical positions of the sub-pixel 20. Such arrangement not only improves the structural uniformity of the second electrode 20C arranged corresponding to the sub-pixel 20, but also increases the distance between the two notches 40A. If leakage current occurs at the notches 40A, this manner can disperse the leakage current paths as much as possible, which is beneficial to improving the display uniformity.

In an example, as shown in FIG. 6, the partition portion 40 includes: a first partition portion 40B1 at least partially surrounding the first sub-pixel 201 and including a first notch 40A1; the second partition portion 40B2 at least partially surrounding the second sub-pixel 202 and including a second notch 40A2; and the third partition portion 40B3 at least partially surrounding the third sub-pixel 203 and including a third notch 40A3.

In an example, in some embodiments of the present disclosure, at least two of the orientation of the first notch 40A1, the orientation of the second notch 40A2, and the orientation of the third notch 40A3 are not parallel to each other.

The orientation of the notch 40A of the partition portion 40 refers to a direction from a centroid G of the orthographic projection of the sub-pixel 20 corresponding to the partition portion 40 on the plane of the substrate 10 toward the center C of the notch 40A. The center C of the notch 40A refers to a midpoint of the connecting line between two endpoints of the partition portion 40 forming the notch 40A. As shown in FIG. 6, the partition portion 40 includes a first endpoint D1 and a second endpoint D2. The first endpoint D1 and the second endpoint D2 are located on both sides of the same notch 40A. A midpoint of the connecting line between the first endpoint D1 and the second endpoint D2 is the center C of the notch 40A.

FIG. 6 illustrates the orientation of one of the first notches 40A1 of the first partition portion 40B1 by a first arrow A1, illustrates the orientation of one of the second notches 40A2 of the second partition portion 40B2 by a second arrow A2, and illustrates the orientation of one of the third notches 40A3 of the third partition portion 40B3 by a third arrow A3.

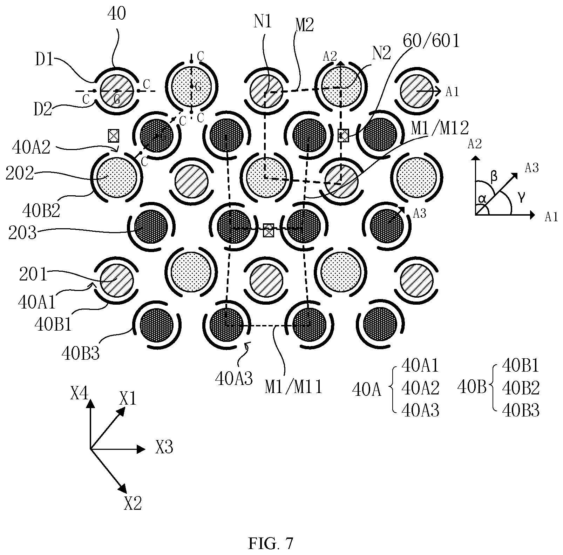

Exemplarily, as shown in FIG. 6, in the embodiments of the present disclosure, the orientation of the first notch 40A1 may not be parallel to the orientation of the second notch 40A2. Alternatively, as shown in FIG. 6, the orientation of the first notch 40A1 may not be parallel to the orientation of the third notch 40A3. Alternatively, as shown in FIG. 7, which is another partially enlarged schematic diagram of a display panel according to an embodiment of the present disclosure, the orientation of the second notch 40A2 may not be parallel to the orientation of the third notch 40A3.

In an example, at least two of the orientation of the first notch 40A1, the orientation of the second notch 40A2, and the orientation of the third notch 40A3 intersect or are perpendicular to each other.

In an example, as shown in FIG. 6 and FIG. 7, the orientation of the first notch 40A1 and the orientation of the second notch 40A2 are not parallel to each other. An included angle α is formed between the direction of the first arrow A1 and the direction of the second arrow A2, where 0<α<180°, so as to increase the distance between the first notch 40A1 and the second notch 40A2 respectively corresponding to the first sub-pixel 201 and the second sub-pixel 202 that are arranged adjacent to each other, thereby increasing the lateral leakage current path between the first sub-pixel 201 and the second sub-pixel 202, and ensuring the light-emitting stability of the first sub-pixel 201 and the second sub-pixel 202.

For example, in some embodiments of the present disclosure, α may be set such that 0°≤α≤90°, for example, 30°≤α≤60°, for example, α=45°.

In an example, as shown in FIG. 6 and FIG. 7, in some embodiments of the present disclosure, the orientation of the first notch 40A1 and the orientation of the second notch 40A2 are perpendicular to each other, that is, the included angle α between the direction of the first arrow A1 and the direction of the second arrow A2 is 90°. Based on such arrangement manner, for multiple second sub-pixels 202 located around the same first sub-pixel 201, the notch 40A corresponding to the first sub-pixel 201 can respectively have a larger distance from the notches 40A of the second sub-pixels 202, thereby reducing the influence of leakage current between the first sub-pixel 201 and each of the second sub-pixels 202 located around the first sub-pixel 201. Similarly, the influence of leakage current between the second sub-pixel 202 and each of multiple first sub-pixels 201 located around the second sub-pixel 202 may also be reduced.

In an example, as shown in FIG. 7, in some embodiments of the present disclosure, the orientation of the second notch 40A2 and the orientation of the third notch 40A3 may be not parallel to each other. An included angle β is formed between the direction of the second arrow A2 and the direction of the third arrow A3, where 0°<β<180°, so as to increase the distance between the second notch 40A2 and the third notch 40A3 respectively corresponding to the second sub-pixel 202 and the third sub-pixel 203 that are arranged adjacent to each other, thereby extending the lateral leakage current path between the second sub-pixel 202 and the third sub-pixel 203, and ensuring the light-emitting stability of the second sub-pixel 202 and the third sub-pixel 203.

For example, in some embodiments of the present disclosure, β may be set such that 90°≤β≤180°, for example, 120°≤β≤150°, for example, β=135°.

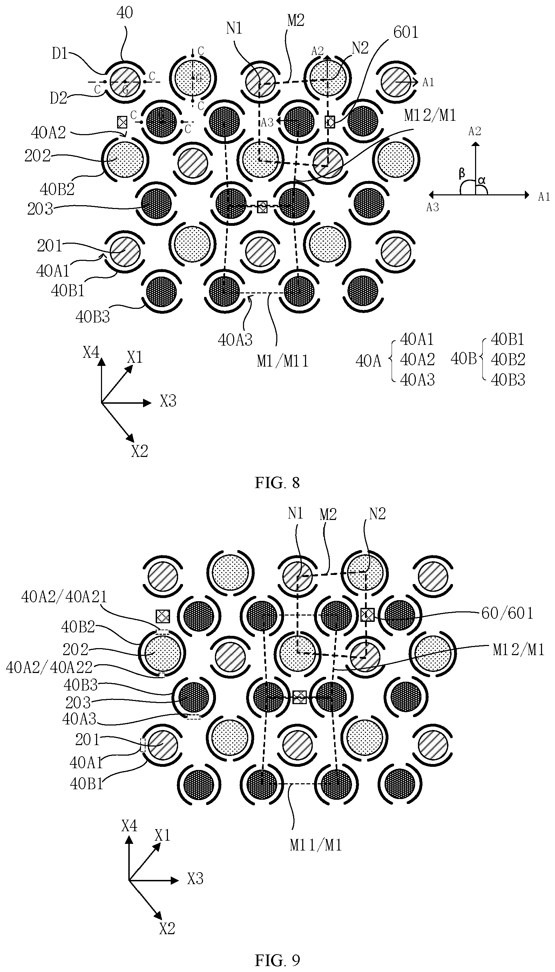

In an example, as shown in FIG. 8, which is another partially enlarged schematic diagram of a display panel according to an embodiment of the present disclosure, the orientation of the second notch 40A2 and the orientation of the third notch 40A3 are perpendicular to each other, that is, an included angle β between the direction of the second arrow A2 and the direction of the third arrow A3 is 90°. Based on such arrangement manner, for multiple second sub-pixels 202 located around the same third sub-pixel 203, the notch 40A corresponding to the third sub-pixel 203 can respectively have a larger distance from the notches 40A of the second sub-pixels 202, thereby reducing the influence of leakage current between the third sub-pixel 203 and each of the second sub-pixels 202 located around the third sub-pixel 203. Similarly, the influence of leakage current between the second sub-pixel 202 and each of multiple third sub-pixels 203 located around the second sub-pixel 202 may also be reduced.

In an example, as shown in FIG. 6 and FIG. 7, in some embodiments of the present disclosure, the orientation of the first notch 40A1 and the orientation of the third notch 40A3 may be not parallel to each other. As shown in FIG. 6 and FIG. 7, the orientation of the first notch 40A1 of the first partition portion 40B1 is illustrated by a first arrow A1, and the orientation of the third notch 40A3 of the third partition portion 40B3 is illustrated by a third arrow A3. An included angle γ is formed between the direction of the first arrow A1 and the direction of the third arrow A3, where 0°<γ<180°, so as to increase the distance between the first notch 40A1 and the third notch 40A3 respectively corresponding to the first sub-pixel 201 and the third sub-pixel 203 that are arranged adjacent to each other. Thus, the lateral leakage current path between the first sub-pixel 201 and the third sub-pixel 203 is extended, and the light leakage phenomenon is mitigated, thereby ensuring the light-emitting stability of the first sub-pixel 201 and the third sub-pixel 203.

For example, in some embodiments of the present disclosure, γ may be set such that 0°≤γ≤90°, for example, 30°≤γ≤60°, for example, γ=45°.

In an example, as shown in FIG. 6, in some embodiments of the present disclosure, the orientation of the first notch 40A1 and the orientation of the third notch 40A3 may be perpendicular to each other, that is, the included angle γ between the direction of the first arrow A1 and the direction of the third arrow A3 is 90°. Based on such arrangement manner, for multiple first sub-pixels 201 located around the same third sub-pixel 203, the notch 40A corresponding to the third sub-pixel 203 can respectively have a larger distance from the notches 40A of the first sub-pixels 201, thereby reducing the influence of leakage current between the third sub-pixel 203 and each of the first sub-pixels 201 located around the third sub-pixel 203. Similarly, the influence of leakage current between the first sub-pixel 201 and each of multiple third sub-pixels 203 located around the first sub-pixel 201 may also be reduced.

In an example, as shown in FIG. 6, FIG. 7 and FIG. 8, in some embodiments of the present disclosure, distances between endpoints of at least two notches 40A corresponding to the same sub-pixel 20 may be equal to each other, so as to improve the structural consistency among the notches 40A, thereby improving the efficiency of preparing the notches 40A, facilitating improving the structural uniformity of the prepared second electrode 20C, and ensuring that the structural thicknesses and shape of the second electrode 20C at the notches 40A are similar.

In another optional implementation, as shown in FIG. 9, which is another partially enlarged schematic diagram of a display panel according to an embodiment of the present disclosure, the partition portion 40 includes a second partition portion 40B2 at least partially surrounding the second sub-pixel 202. The second partition portion 40B2 includes at least two second notches 40A2. In some embodiments of the present disclosure, distances between endpoints of the at least two second notches 40A2 are different, so that sizes of the at least two second notches 40A2 are different. In the embodiments of the present disclosure, the two second notches 40A2 in the second partition portion 40B2 are configured differentially. During the design of the display panel, different sizes of the second notches 40A2 may be prepared according to the position of each of the second notches 40A2, for example, according to parameters such as a distance between each of second notches 40A2 and an adjacent sub-pixel, thereby making the design of the second notches 40A2 more flexible, and further fully utilizing the positional characteristics of the second notches 40A2.

In another optional implementation, in some embodiments of the present disclosure, distances between endpoints of the at least two first notches 40A1 included in the first partition portion 40B1 may be different, or distances between endpoints of the at least two third notches 40A3 included in the third partition portion 40B3 may be different.

In an example, as shown in FIG. 6, FIG. 7, FIG. 8 and FIG. 9, in some embodiments of the present disclosure, third sub-pixels 203 may form a first virtual trapezoid M1. The centers of the third sub-pixels 203 are respectively located at vertices of the first virtual trapezoid M1, and the first sub-pixel 201 or the second sub-pixel 202 are located inside the first virtual trapezoid M1.

Exemplarily, as shown in FIG. 6, FIG. 7, FIG. 8 and FIG. 9, the first virtual trapezoid M1 may include a first virtual sub-trapezoid M11 and a second virtual sub-trapezoid M12. The first virtual sub-trapezoid M11 may surround the first sub-pixel 201, that is, the first sub-pixel 201 is located inside the first virtual sub-trapezoid M11. The second virtual sub-trapezoid M12 may surround the second sub-pixel 202, that is, the second sub-pixel 202 is located inside the second virtual sub-trapezoid M12.

Among two bases of the first virtual trapezoid M1, a distance between the third sub-pixels 203 at the two vertices corresponding to the shorter base is less than a distance between the third sub-pixels 203 at the two vertices corresponding to the longer base.

Exemplarily, with continued reference to FIG. 6, FIG. 7, FIG. 8, and FIG. 9, the first sub-pixels 201 and the second sub-pixels 202 form a second virtual trapezoid M2. The centers of the second sub-pixels 202 are located at first vertexes N1 of the second virtual trapezoid M2, and the centers of the first sub-pixels 201 are located at second vertexes N2 of the second virtual trapezoid M2. The first vertexes N1 and the second vertexes N2 are alternately spaced apart, and the third sub-pixel 203 is located inside the second virtual trapezoid M2.

Exemplarily, among two bases of the second virtual trapezoid M2, a distance between the first sub-pixel 201 and the second sub-pixel 202 at the two vertices corresponding to the shorter base is smaller than a distance between the first sub-pixel 201 and the second sub-pixel 202 at the two vertices corresponding to the longer base. The third sub-pixel 203 is surrounded by the second virtual trapezoid M2 formed by the first sub-pixels 201 and the second sub-pixels 202.

In an example, as shown in FIG. 1, FIG. 6, FIG. 7, FIG. 8, and FIG. 9, the display panel 100 further includes a support portion 60. In an example, the support portion 60 may be configured to support a mask plate used in the preparation process of the display panel 100, so as to prevent the mask plate from directly contacting multiple film layers in the sub-pixels 20, thereby preventing the surface of important regions such as the light-emitting regions from being scratched by the mask plate.

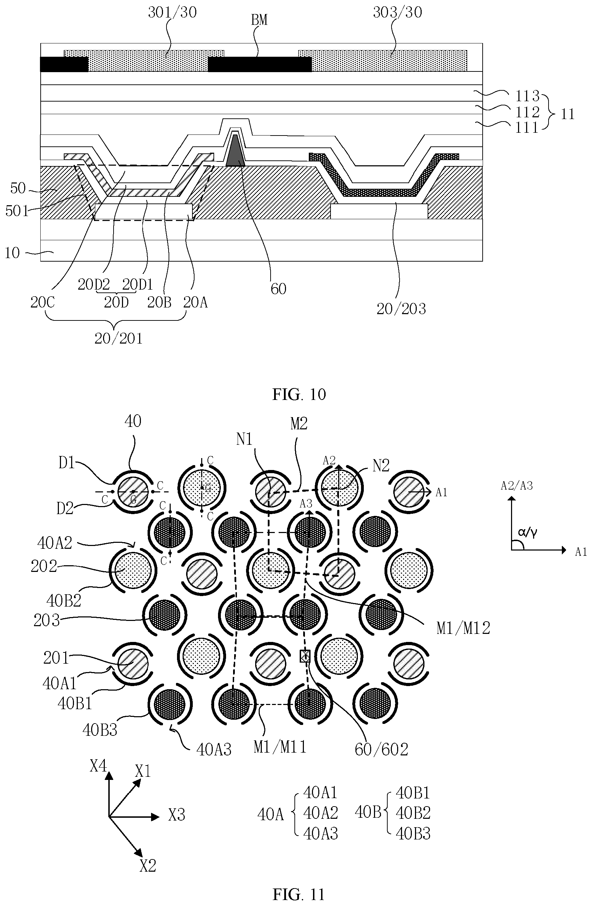

In some embodiments of the present disclosure, the support portion 60 may have a structure similar to the protrusion 401 for forming the partition portion 40 shown in FIG. 2. Referring to FIG. 10, which is another cross-sectional schematic diagram of a display panel according to an embodiment of the present disclosure, along the direction h2 perpendicular to the plane of the substrate 1, the support portion 60 protrudes from a surface of the pixel definition layer 50 away from the substrate 10. Exemplarily, when the partition portion 40 is configured to include the protrusion 401 shown in FIG. 2 and FIG. 3, the height of the support portion 60 may be greater than or equal to the height of the protrusion 401.

Exemplarily, as shown in FIG. 6, FIG. 7, FIG. 8, and FIG. 9, at least part of the support portion 60 is located on an edge of the first virtual trapezoid M1. A distance between two adjacent sub-pixels 20 located on the edge of the first virtual trapezoid M1 is greater than a distance between sub-pixels located at other positions. In the embodiments of the present disclosure, at least part of the support portion 60 is arranged at the edge of the first virtual trapezoid M1, so as to reduce the difficulty of preparing the support portion 60, and to reduce the possibility that the support portion 60 slides into the pixel openings located around the support portion 60.

In an example, as shown in FIG. 9, the second partition portion 40B2 includes at least two second notches 40A2. The at least two second notches 40A2 include a first sub-notch 40A21 and a second sub-notch 40A22. A distance between two endpoints of the first sub-notch 40A21 is greater than a distance between two endpoints of the second sub-notch 40A22.

In some embodiments of the present disclosure, at least part of the support portion 60 is located on a side of the first sub-notch 40A21 away from the second sub-notch 40A22. Based on such arrangement manner, the distance between the non-notch position of the second partition portion 40B2 and the support portion 60 can be increased, which not only makes full use of the space on the display panel 100 to improve the pixel density, but also reduces the arrangement difficulty of the support portion 60. In addition, the support portion 60 also has a certain partition function for the lateral leakage current, so that the arrangement of the notch 40 facing the support portion 60 does not cause crosstalk between the sub-pixels 2 of different colors located on both sides of the notch 40.

In an example, as shown in FIG. 1, FIG. 6, FIG. 7, FIG. 8 and FIG. 9, the support portion 60 includes a first support portion 601. Along the third direction X3, the first support portion 601 is located between two adjacent third sub-pixels 203. Along the fourth direction X4, the first support portion 601 is located between the first sub-pixel 201 and the second sub-pixel 202. The third direction X3 intersects with the fourth direction X4. The third direction X3 respectively intersects with the first direction X1 and the second direction X2, and the fourth direction X4 respectively intersects with the first direction X1 and the second direction X2.

Exemplarily, as shown in FIG. 9, the first sub-pixel 201 includes two first notches 40A1 arranged along the third direction X3. The second sub-pixel 202 includes two second notches 40A2. One of the two second notches 40A2 is located on a side of the second sub-pixel 202 close to the first support portion 601, and the other one of the two second notches 40A2 is located on a side of the second sub-pixel 202 away from the first support portion 601. That is, among the two second notches 40A2 included in the second partition portion 40B2, only the orientation of one second notch 40A2 points to the first support portion 601.

As shown in FIG. 9, the third sub-pixel 203 includes two third notches 40A3 arranged along the fourth direction X4.

In an example, as shown in FIG. 1 and FIG. 11, where FIG. 11 is another partial enlarged schematic diagram of a display panel according to an embodiment of the present disclosure, the support portion 60 further includes a second support portion 602. Along the third direction X3, the second support portion 602 is located between the first sub-pixel 201 and the second sub-pixel 202. Along the fourth direction X4, the second support portion 602 is located between two adjacent third sub-pixels 203.

As shown in FIG. 11, the first sub-pixel 201 includes two first notches 40A1. Along the third direction X3, one of the two first notches 40A1 is located on a side of the first sub-pixel 201 close to the second support portion 602, and the other one of the two first notches 40A1 is located on a side of the first sub-pixel 201 away from the second support portion 602. The second sub-pixel 202 includes two second notches 40A2 arranged along the fourth direction X4. The third sub-pixel 203 includes two third notches 40A3. Along the fourth direction X4, one of the two third notches 40A3 is located on a side of the third sub-pixel 203 close to the second support portion 602, and the other one of the two third notches 40A3 is located on a side of the third sub-pixel 203 away from the second support portion 60. That is, the two notches arranged corresponding to the third sub-pixel 203 and the two notches arranged corresponding to the first sub-pixel 201 both include one notch 40A, an orientation of which points to the second support portion 602, so as to increase the distance between the second support portion 602 and the non-notch position of the partition portion, and to reduce the difficulty of preparing the second support portion 602.

The first support portion 601 and the second support portion 602 may be arranged corresponding to positions having different notch distribution rules in the display panel, which may improve the consistency of the supporting effect at positions having different notch distribution rules in the display panel.

Exemplarily, as shown in FIG. 1, the display panel includes at least one first group G1. A plurality of first groups G1 are arranged in an array along the third direction X3 and the fourth direction X4. The third direction X3 intersects with the fourth direction X4. The third direction X3 respectively intersects the first direction X1 and the second direction X2, and the fourth direction X4 respectively intersects the first direction X1 and the second direction X2.

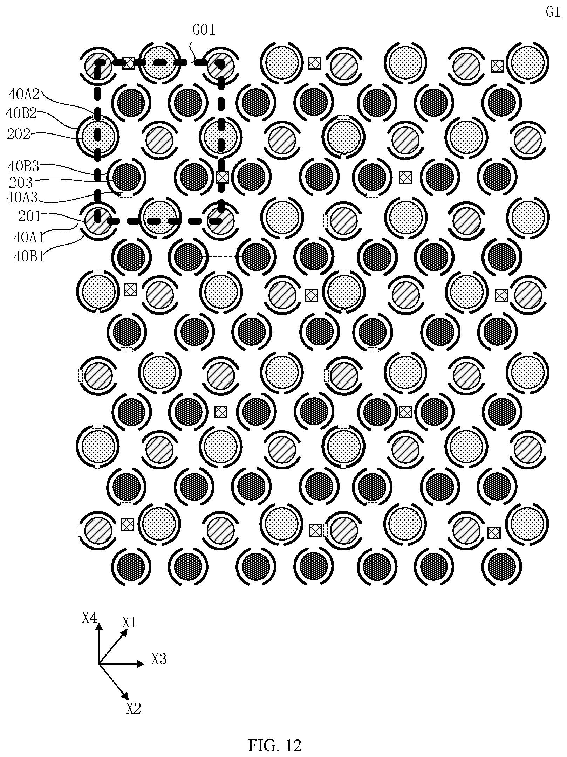

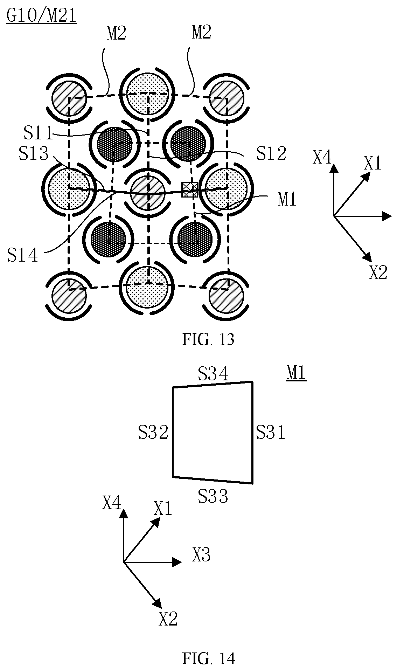

As shown in FIG. 12, which is an enlarged schematic diagram of a first group according to an embodiment of the present disclosure, the first group G1 includes a plurality of first subgroups G10 and a plurality of support portions 60. Referring to FIG. 13, which is an enlarged schematic diagram of a first subgroup according to an embodiment of the present disclosure, the first subgroup G10 includes the first virtual trapezoid M1.

As shown in FIG. 13, the first subgroup G10 further includes m1×n1 second virtual trapezoids M2 arranged along the third direction X3 and the fourth direction X4. FIG. 13 takes m1=2 and n1=2 as an example.

As shown in FIG. 14, which is a simplified schematic diagram of an outline of a second virtual trapezoid according to an embodiment of the present disclosure, the second virtual trapezoid includes a first edge S31 and a second edge S32 that are arranged opposite each other along the third direction X3, and a third edge S33 and a fourth edge S34 that are arranged opposite each other along the fourth direction X4.

In the embodiments of the present disclosure, along the third direction X3, among two adjacent second virtual trapezoids M2 in the first subgroup G10, the first edge S31 of one second virtual trapezoid M2 is reused as the second edge S32 of the other second virtual trapezoid M2. Along the fourth direction X4, among two adjacent second virtual trapezoid M2 in the first subgroup G10, the third edge S33 of one second virtual trapezoid M2 is reused as the fourth edge S34 of the other second virtual trapezoid M2. Based on such arrangement manner, a plurality of first subgroups G10 can be arranged in an array while sharing common edges to form the first group G1, which can improve the regularity of patterns including sub-pixels and partition portions in the first group G1, thereby facilitating improving process efficiency.

Exemplarily, as shown in FIG. 12, the first group G1 includes m2×n2 first subgroups G10 arranged in the third direction X3 and the fourth direction X4. FIG. 12 takes m2=3 and n2=3 as an example.

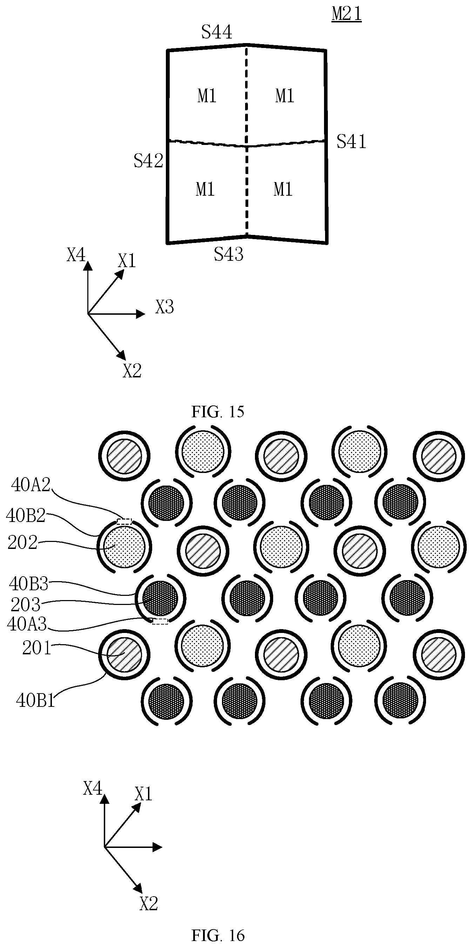

As shown in FIG. 13 and FIG. 15, where FIG. 15 is a simplified schematic diagram of an outline of a first subgroup according to an embodiment of the present disclosure, the first subgroup G10 includes a first virtual polygon M21. As shown in FIG. 15, the first virtual polygon M21 includes a fifth edge S41 and a sixth edge S42 that are arranged opposite each other along the third direction X3, and a seventh edge S43 and a fourth edge S44 that are arranged opposite each other along the fourth direction X4.

In some embodiments of the present disclosure, along the third direction X3, among two adjacent first subgroups G10 in the first group G1, the fifth edge S41 of one first subgroup G10 is reused as the eighth edge S44 of the other first subgroup G10. Along the fourth direction X4, among two adjacent first subgroups G10 in the first group G1, the seventh edge S43 of one first subgroup G10 is reused as the eighth edge S44 of the other first subgroup G10. Exemplarily, as shown in FIG. 15, the seventh edge S43 and the eighth edge S44 may be broken lines.

Based on the arrangement manner provided by the embodiments of the present disclosure, the first group G1 may serve as a repeating unit including the sub-pixels 20, the partition portions 40 and the support portions 60. That is, the first groups G1 may be repeatedly arranged while sharing edges to fully cover the display area of the display panel, which is beneficial to improving the distribution regularity of patterns including the sub-pixels 20, the partition portions 40 and the support portions 60 in the display panel, thereby facilitating process production.

Exemplarily, with reference to FIG. 6, FIG. 7, FIG. 8, FIG. 9, FIG. 11, and FIG. 12, according to the embodiments of the present disclosure, orientations of the notches 40A of two adjacent first partition portions 40B1 in the third direction X3 are the same, and orientations of the notches 40A of two adjacent first partition portions 40B1 in the fourth direction X4 are the same. Such arrangement manner is beneficial to reducing the size of the first group G1 as a repeating unit, thereby simplifying the design, and facilitating process monitoring during the preparation process, so as to improve both process yield and efficiency.

In another optional implementation, as shown in FIG. 16, which is another partial enlarged schematic diagram of a display panel according to an embodiment of the present disclosure, in some embodiments of the present disclosure, the first partition portion 40B1 at least partially surrounding the first sub-pixel 201 may not include a notch 40A.

Exemplarily, the first sub-pixel 201 may be one of the various sub-pixels in the display panel 100 that has a lower turn-on voltage. That is, the first sub-pixel 201 is more sensitive to leakage current, and such leakage current is more likely to induce brightness fluctuations in the first sub-pixel 201. In the embodiments of the present disclosure, the first partition portion 40B1 arranged corresponding to the first sub-pixel 201 does not include a notch, so as to extend the leakage current path between the first sub-pixel 201 and an adjacent sub-pixel 20, thereby reducing the influence of leakage current from the adjacent sub-pixel 20 on the first sub-pixel 201, and improving the light-emitting brightness accuracy of the first sub-pixel 201.

In an example, the first sub-pixel 201 is a red sub-pixel.

In another optional implementation, with continued reference to FIG. 6, FIG. 7, FIG. 8, FIG. 9 and FIG. 10, in the embodiments of the present disclosure, the partition portion 40 corresponding to any one of the first sub-pixel 201, the second sub-pixel 202 and the third sub-pixel 203 has only two notches 40A, so as to balance the effects of suppressing the lateral leakage current of the sub-pixels and improving the reliability of the second electrode 20C.

Exemplarily, as shown in FIG. 1, FIG. 6, FIG. 7, FIG. 8, FIG. 9, and FIG. 11, a shape of an orthographic projection of the partition portion 40 on the plane of the substrate 10 includes an arc, so that the structure of the partition portion 40 follows the shape of the prepared sub-pixel 20, thereby avoiding the situation in which a light-emitting region of the sub-pixel 20 is covered when structures of the sub-pixels 20 partially surrounded by the partition portion 40 and the partition portion 40 are inconsistent, and ensuring that structures of a plurality of film layers prepared after the formation of the partition portion 40 are more standardized.

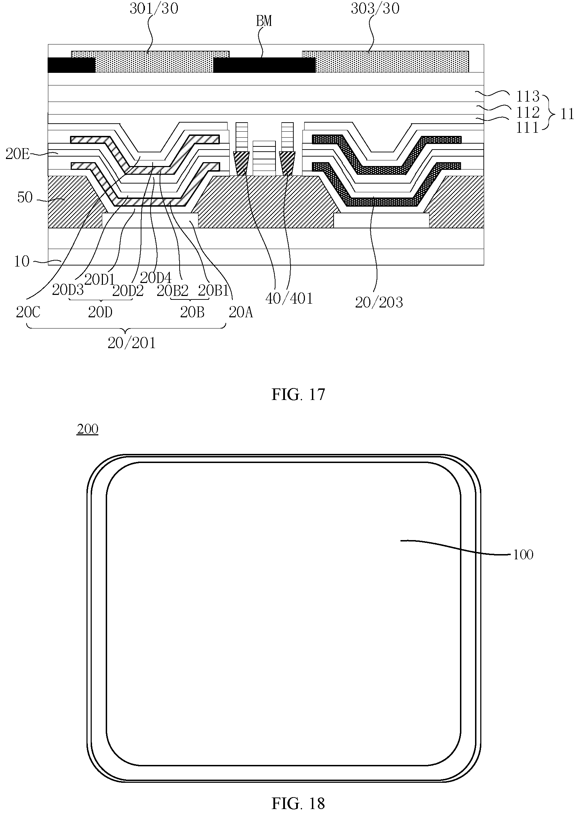

In an example, as shown in FIG. 17, which is another cross-sectional schematic diagram of a display panel according to an embodiment of the present disclosure, the sub-pixel 20 includes a first electrode 20A, a first light-emitting layer 20B1, a charge generation layer 20E, a second light-emitting layer 20B2 and a second electrode 20C. The first electrode 20A is located on a side of the substrate 10, the first light-emitting layer 20B1 is located on a side of the first electrode 20A away from the substrate 10, at least part of the first light-emitting layer 20 B1 is located in the opening 501 of the pixel definition layer 50, and the opening 501 may be a pixel opening. The charge generation layer 20E is located on a side of the first light-emitting layer 20B1 away from the first electrode 20A. The second light-emitting layer 20B2 is located on a side of the charge generation layer 20E away from the first light-emitting layer 20B1. The second electrode 20C is located on a side of the second light-emitting layer 20B1 away from the charge generation layer 20E. The charge generation layer 20E is located between the first light-emitting layer 20B1 and the second light-emitting layer 20B2.

Exemplarily, as shown in FIG. 17, the charge generation layer 20E may be disconnected at the position of the partition portion 40. Alternatively, in some other embodiments, the charge generation layer 20E may also be arranged to protrude away from the substrate 10 at the partition portion 40, so as to increase the transmission path of the lateral leakage current in the charge generation layer 20E.

In an example, as shown in FIG. 17, taking the first electrode 20A as an anode and the second electrode 20C as a cathode as an example, the common layer 20D further includes a third common sub-layer 20D3 and a fourth common sub-layer 20D4. The third common sub-layer 2D3 may serve as an electron transport layer for transporting electrons to the first light-emitting layer 20B1. The fourth common sub-layer 20D4 may serve as a hole transport layer for transporting holes to the second light-emitting layer 20B2.

According to the display panel 100 provided by the embodiments of the present disclosure, the sub-pixel 20 is designed as a series structure including the first light-emitting layer 20B1 and the second light-emitting layer 20B2 that are stacked, improving the light-emitting brightness of the sub-pixel 20, reducing the power consumption of the display panel 100, and prolonging the service life of the display panel 100. In addition, in the embodiments of the present disclosure, by providing the partition portion 40 in the display panel 100, the lateral leakage current between two adjacent sub-pixels 20 can be suppressed or partitioned, thereby overcoming the crosstalk between adjacent sub-pixels 20 caused by the high conductivity of the charge generation layer 20E, and being advantageous for improving the display quality of the display panel 100.

Based on the same inventive concept, an embodiment of the present disclosure further provides a display device, as shown in FIG. 18, which is a schematic diagram of a display device according to an embodiment of the present disclosure, the display device 200 includes the above display panel 100. The specific structure of the display panel 100 has been described in detail in the foregoing embodiments, and details are not described herein again. It is understandable that the display device shown in FIG. 18 is merely illustrative, and the display device may be any electronic device having a display function such as a mobile phone, a tablet computer, a notebook computer, an e-book, and a television.

The above description is only a preferred embodiment of the present disclosure and is not intended to limit the present disclosure, and any modifications, equivalent substitutions, improvements and the like made within the spirit and principle of the present disclosure should be included within the scope of the present disclosure.

As above, it should be noted that, the above-described embodiments are merely for illustrating the present disclosure but not intended to provide any limitation. Although the present disclosure has been described in detail with reference to the above-described embodiments, it should be understood by those skilled in the art that, it is still possible to modify the technical solutions described in the above embodiments or to equivalently replace some or all of the technical features therein, but these modifications or replacements do not cause the essence of corresponding technical solutions to depart from the scope of the present disclosure.

## Claims

1. A display panel, comprising:
a substrate;
a plurality of sub-pixels located on a same side of the substrate, wherein the plurality of sub-pixels comprise first sub-pixels, second sub-pixels, and third sub-pixels, an i-th row of the plurality of sub-pixels comprises the first sub-pixels and the third sub-pixels alternately arranged along a first direction; an (i+1)-th row of the plurality of sub-pixels comprises the second sub-pixels and the third sub-pixels alternately arranged along the first direction; a j-th column of the plurality of sub-pixels comprises the first sub-pixels and the third sub-pixels alternately arranged along a second direction; a (j+1)-th column of the plurality of sub-pixels comprises the second sub-pixels and the third sub-pixels alternately arranged along the second direction; and a shape of at least one of the first sub-pixels, the second sub-pixels, and the third sub-pixels comprises a circle;
a plurality of color resist layers located on a side of the plurality of sub-pixels away from the substrate, wherein the plurality of color resist layers comprise a first color resist layer, a second color resist layer and a third color resist layer; and along a direction perpendicular to a plane of the substrate, the first color resist layer at least partially overlaps with one of the first sub-pixels, the second color resist layer at least partially overlaps with one of the second sub-pixels, and the third color resist layer at least partially overlaps with one of the third sub-pixels; and
a plurality of partition portions, wherein the plurality of partition portions partially surround the sub-pixels, and at least one of the plurality of partition portions comprises a notch.

2. The display panel according to claim 1, wherein a partition portion of the plurality of partition portions corresponding to at least one of the first sub-pixels, the second sub-pixels and the third sub-pixels comprises two notches.

3. The display panel according to claim 2, wherein a connecting line between centers of the two notches passes through a centroid of an orthographic projection of a corresponding sub-pixel of the plurality of sub-pixels on the plane of the substrate.

4. The display panel according to claim 2, wherein the plurality of partition portions comprise:
a first partition portion at least partially surrounding one of the first sub-pixels, wherein the first partition portion comprises a first notch;
a second partition portion at least partially surrounding one of the second sub-pixels, wherein the second partition portion comprises a second notch; and
a third partition portion at least partially surrounding one of the third sub-pixels, wherein the third partition portion comprises a third notch,
wherein at least two of an orientation of the first notch, an orientation of the second notch and an orientation of the third notch are not parallel to each other.

5. The display panel according to claim 4, wherein the orientation of the first notch is not parallel to the orientation of the second notch, and the orientation of the first notch is perpendicular to the orientation of the second notch.

6. The display panel according to claim 4, wherein the orientation of the second notch is not parallel to the orientation of the third notch, and the orientation of the second notch is perpendicular to the orientation of the third notch.

7. The display panel according to claim 4, wherein the orientation of the first notch is not parallel to the orientation of the third notch, and the orientation of the first notch is perpendicular to the orientation of the third notch.

8. The display panel according to claim 2, wherein distances between endpoints of the two notches are equal.

9. The display panel according to claim 1, wherein the plurality of partition portions comprise a second partition portion at least partially surrounding one of the second sub-pixels, wherein the second partition portion comprises at least two second notches, and distances between endpoints of the at least two second notches are different.

10. The display panel according to claim 1, wherein a plurality of the third sub-pixels form a first virtual trapezoid, centers of the plurality of the third sub-pixels are respectively located at vertices of the first virtual trapezoid, and a first sub-pixel of the first sub-pixels is located inside the first virtual trapezoid;
a plurality of the first sub-pixels and a plurality of the second sub-pixels form a second virtual trapezoid, centers of the plurality of the second sub-pixels are located at first vertices of the second virtual trapezoid, and centers of the plurality of the first sub-pixels are located at second vertices of the second virtual trapezoid; and
the first vertices and the second vertices are alternately arranged and spaced apart, and a third sub-pixel of the third sub-pixels is inside the second virtual trapezoid.

11. The display panel according to claim 10, further comprising:
a support portion partially located on an edge of the first virtual trapezoid.

12. The display panel according to claim 11, wherein the second partition portion comprises at least two second notches, the at least two second notches comprise a first sub-notch and a second sub-notch, and a distance between two endpoints of the first sub-notch is greater than a distance between two endpoints of the second sub-notch; and
the support portion is partially located on a side of the first sub-notch away from the second sub-notch.

13. The display panel according to claim 11, wherein the support portion comprises a first support portion, wherein the first support portion is located between two adjacent third sub-pixels of the third sub-pixels along a third direction; the first support portion is located between one of the first sub-pixels and one of the second sub-pixels along a fourth direction; the third direction intersects with the fourth direction, the third direction respectively intersects with the first direction and the second direction, and the fourth direction respectively intersects with the first direction and the second direction;
the first sub-pixels respectively comprise two first notches arranged along the third direction;
the second sub-pixels respectively comprise two second notches, one of the two second notches is located on a side of a corresponding second sub-pixel of the second sub-pixels close to the support portion, and the other one of the two second notches is located on a side of the corresponding second sub-pixel of the second sub-pixels away from the support portion; and
the third sub-pixels respectively comprise two third notches arranged along the fourth direction.

14. The display panel according to claim 11, wherein the support portion comprises a second support portion, wherein the second support portion is located between one of first sub-pixels and one of the second sub-pixels along the first direction; and the second support portion is located between two adjacent third sub-pixels of the third sub-pixels along a fourth direction;
the first sub-pixels respectively comprise two first notches, one of the two first notches is located on a side of a corresponding first sub-pixel of the first sub-pixels close to the second support portion, and the other one of the two first notches is located on a side of the corresponding first sub-pixel of the first sub-pixels away from the second support portion;
the second sub-pixels respectively comprise two second notches arranged along the fourth direction; and
the third sub-pixels respectively comprise two third notches, one of the two third notches is located on a side of a corresponding third sub-pixel of the third sub-pixels close to the second support portion, and the other one of the two third notches is located on a side of the corresponding third sub-pixel of the third sub-pixels away from the support portion.

15. The display panel according to claim 1, wherein a shape of an orthographic projection of one of the plurality of partition portions on the plane of the substrate comprises an arc.

16. The display panel according to claim 1, wherein the plurality of partition portions comprise:
first partition portions at least partially surrounding one of the first sub-pixels respectively;
second partition portions at least partially surrounding one of the second sub-pixels respectively; and
third partition portions at least partially surrounding one of the third sub-pixels respectively,
wherein orientations of notches of two adjacent first partition portions of the first partition portions in a third direction are the same; orientations of notches of two adjacent first partition portions of the first partition portions in a fourth direction are the same; the third direction intersects with the fourth direction, the third direction respectively intersects with the first direction and the second direction, and the fourth direction respectively intersects with the first direction and the second direction,
wherein orientations of notches of two adjacent second partition portions of the second partition portions in the third direction are the same; and orientations of notches of two adjacent second partition portions of the second partition portions in the fourth direction are the same, and
wherein orientations of notches of two adjacent third partition portions of the third partition portions in the third direction are the same; and orientations of notches of two adjacent third partition portions of the third partition portions in the fourth direction are the same.

17. The display panel according to claim 1, wherein the plurality of partition portions comprise a first partition portion at least partially surrounding one of the first sub-pixels, and the first partition portion does not comprise a notch.

18. The display panel according to claim 1, wherein a partition portion of the plurality of partition portions corresponding to any one of the first sub-pixels, the second sub-pixels and the third sub-pixels has two notches.

19. The display panel according to claim 1, wherein the plurality of sub-pixels respectively comprise:
a first electrode located at a side of the substrate;
a first light-emitting layer located on a side of the first electrode away from the substrate, wherein at least part of the first light-emitting layer is located in an opening;
a charge generation layer located at a side of the first light-emitting layer away from the first electrode;
a second light-emitting layer located at a side of the charge generation layer away from the first light-emitting layer; and
a second electrode located at a side of the second light-emitting layer away from the charge generation layer.

20. The display panel according to claim 1, wherein the plurality of partition portions respectively comprise at least one of a first partition sub-portion and a second partition sub-portion,
wherein the first partition sub-portion comprises a protrusion protruding away from the substrate, and an area of a surface of the protrusion away from the substrate is greater than an area of a surface of the protrusion close to the substrate; and the second partition sub-portion comprises a recess recessed toward the substrate.

21. A display device, comprising the display panel according to any one of claims 1 to 20.
